# EUROPÄISCHE PATENTSCHRIFT

(11) **EP 2 073 262 B1**
(45) Veröffentlichungstag und Bekanntmachung des Hinweises auf die Patenterteilung: **30.09.2015**
(21) Anmeldenummer: 07024487.6
(22) Anmeldetag: 18.12.2007
(51) Int. Cl.: H01L 23/31

(54) **Halbleiterbauelement**
Semiconductor component
Composant semi-conducteur

(43) Veröffentlichungstag der Anmeldung: 24.06.2009
(73) Patentinhaber: Micronas GmbH, 79108 Freiburg i. Br. (DE)
(72) Erfinder: Kredler, Stefan, 79194 Heuweiler (DE); Bidenbach, Reiner, 79279 Vörstetten (DE); Schubert, Jens, 79111 Freiburg (DE); Heberle, Klaus, 79312 Emmendingen (DE)
(74) Vertreter: Koch Müller Patentanwaltsgesellschaft mbH

(56) Entgegenhaltungen:
- EP-A- 1 276 142
- WO-A-03/039217
- DE-A1- 3 710 865
- JP-A- 3 094 438
- JP-A- 2002 305 265
- JP-A- 2003 347 482
- US-A1- 2007 152 215
- US-A1- 2007 200 257

## Beschreibung

Die Erfindung betrifft ein Halbleiterbauelement nach dem Oberbegriff von Anspruch 1.

Ein derartiges Halbleiterbauelement ist aus US 2007/0152215 A1 bekannt. Es hat einen Halbleiterchip, in den eine elektrische Schaltung integriert ist und der Anschlussflächen für Testssignale aufweist. Der Halbleiterchip ist von einer die Anschlussflächen bereichsweise überdeckenden elektrisch isolierenden Verkapselungsmasse umgrenzt. Jede Anschlussfläche ist mit einem über die Oberfläche des Halbleiterchips überstehenden, im Inneren der Verkapselungsmasse angeordneten Analysekontakt elektrisch leitend verbunden, der an der Unterseite des Halbleiterbauelements jeweils einen freiliegenden Bereich aufweist, an dem der Analysekontakt einer externen Testeinrichtung elektrisch verbunden werden kann. Die freiliegenden Bereiche der Analysekontakte werden nach dem Testen des Halbleiterbauelements mit Epoxydharz abgedichtet. Hierdurch wird jedoch ein zusätzlicher Fertigungsschritt erforderlich.

Auch aus JP 2003 347482 A ist ein Halbleiterbauelement nach dem Oberbegriff von Anspruch 1 bekannt. Bei diesem Halbleiterbauelement sind die freiliegenden Bereiche der Analysekontakte nicht abgedeckt. Dadurch können Sie beim Betrieb des Halbleiterchips mit elektrisch leitenden Teilen und/oder aggressiven Medien in Berührung geraten, wodurch die Funktion des Halbleiterchips gestört werden kann.

Aus JP 03 094438 A ist außerdem ein Halbleiterbauelement bekannt, das einen Halbleiterchip aufweist, der von einer elektrisch isolierenden Verkapselungsmasse umgrenzt ist. Das Halbleiterbauelement hat mehrere, in die Verkapselungsmasse eingebettete Anschlusskontakte, die mit elektrischen Anschlussstellen des Halbleiterchips verbunden sind. Eine Anschlussstelle für ein Testsignal ist bei diesem Halbleiterchip nicht vorhanden.

Aus DE 37 10 865 A1 ist ferner ein gattungsfremder Halbleiterchip bekannt, der einen Konstantspannungsgenerator und eine damit verbundene integrierte Schaltung aufweist um eine extern angelegte Versorgungsspannung zu empfangen, damit eine eingestellte Gleichspannung erzeugt wird, deren Potentialpegel niedriger als derjenige der externen Spannungsversorgung ist. Ein Betriebsarten-Ansteuerungsglied liegt parallel zum Spannungsgenerator, um in einer ersten Betriebsart die Ausgangsgleichspannung des Spannungsgenerators an die integrierte Schaltung anzulegen. Wenn der Halbleiterchip einem beschleunigten Test mittels einer erhöhten Versorgungsspannung unterzogen wird, wird in einer zweiten Betriebsart die externe Versorgungsspannung über einen Schalttransistor direkt an die integrierte Schaltung angelegt. Die Betriebsartenumschaltung erfordert jedoch einen gewissen schaltungstechnischen Mehraufwand.

Aus US 2007/0200257 A1 ist außerdem eine gattungsfremde Chipanordnung bekannt, die zwei übereinander gestapelte Halbleiterchips aufweist, die einander zugewandte Anschlussflächen aufweisen, die über Anschlusskontakte (Ball-Bonds) miteinander verbunden sind. Die Anschlusskontakte sind derart in eine den betreffenden Halbleiterchip umgrenzende Verkapselungsmasse eingelassen, dass sie über die Außenoberfläche der Verkapselungsmasse überstehen bzw. aus dieser herausragen. Eine Anschlussstelle für ein Testsignal ist bei dieser Chipanordnung nicht vorgesehen.

Aus der Praxis ist ferner ein Halbleiterbauelement bekannt, das mehrere von der Verkapselungsmasse umgrenzte, von außen zugängliche Anschlusskontakte hat, die über in die Verkapselungsmasse eingebettete Bonddrähte mit elektrischen Anschlussstellen des Halbleiterchips verbunden sind. Dabei sind die Bonddrähte jeweils an ihrem einen Ende über eine erst Bondverbindung mit dem Halbleiterchip und an ihrem anderen Ende über eine zweite Bondverbindung mit dem betreffenden Anschlusskontakt verbunden. Außerdem weist der Halbleiterchip an seiner Oberfläche Anschlussflächen auf, die von der Verkapselungsmasse überdeckt und durch Abtragen der Verkapselungsmasse freilegbar sind. An den freigelegten Anschlussflächen können mit Hilfe von Messnadeln interne elektrische Signale einer in den Halbleiterchip integrierten elektrischen Schaltung abgegriffen werden. Dadurch ist es möglich, beim Auftreten eines elektrischen Defekts an dem Halbleiterbauelement einen von dem Defekt betroffenen Schaltungsteil zu lokalisieren und/oder Rückschlüsse auf die Ursache des Defekts zu ziehen. Eine derartige Überprüfung eines defekten Halbleiterchips kann insbesondere zu Qualitätssicherung in einem Halbleiterwerk durchgeführt werden, um Fehler bei der Fertigung des Halbleiterbauelements, die später zu einem Ausfall des Halbleiterbauelement führen können, aufzufinden und zu beseitigen.

Das Halbleiterbauelement hat jedoch den Nachteil, dass der Halbleiterchip und/oder die Bonddrähte, welche die Anschlussstellen des Halbleiterchips mit den von außen zugänglichen Anschlusskontakten verbinden, beim Abtragen der Verkapselungsmasse und/oder bei einem ungeschickten Positionieren der Messnadeln leicht beschädigt werden können, so dass die Ursache des elektrischen Defekts dann nur noch mit entsprechend großem Aufwand oder sogar überhaupt nicht mehr festgestellt werden kann. Ungünstig ist außerdem, dass beim Abtragen der Verkapselungsmasse die Oberfläche des Halbleiterchips freigelegt werden kann, so dass das geöffnete Halbleiterbauelement dann nur noch schlecht handhabbar ist und/oder nicht mehr gegen Umwelteinflüsse geschützt ist. Auch ist die Nadelkontaktierung der Anschlussflächen nur schwer kontrollierbar, weshalb es beispielsweise beim Abrutschen der Messnadeln leicht zu einer mechanischen Beschädigung der Chipoberfläche kommen kann. Darüber hinaus können durch das Entfernen der Verkapselungsmasse Störungen, wie z.B. Artefakte, in den an den Anschlussfläche abgegriffenen Testssignalen auftreten, die nicht von einem durch den elektrischen Defekt verursachten Signal unterschieden werden können.

Es besteht deshalb die Aufgabe, ein Halbleiterbauelement der eingangs genannten Art zu schaffen, bei dem im Fehlerfall die Anschlussfläche für das Testssignal auf einfache Weise von außen kontaktiert werden kann.

Diese Aufgabe wird mit den Merkmalen des Anspruchs 1 gelöst.

In vorteilhafter Weise ermöglicht der erhabene Analysekontakt eine elektrische Kontaktierung der Anschlussfläche für das Testssignal, indem eine oberflächennahe äußere Schicht der Verkapselungsmasse abgetragen wird, während eine an den Halbleiterchip angrenzende innere Schicht der Verkapselungsmasse erhalten bleibt. Somit ist der Halbleiterchip nach dem Freilegen des Analysekontakts weiterhin durch die innere Schicht gegen Umwelteinflüsse und mechanische Beschädigung geschützt. Da die Vergussmasse im inneren, an den Halbleiterchip angrenzenden Bereich weitgehend erhalten bleibt, werden durch das Abtragen der Vergussmasse kaum Artefakte oder dergleichen Störungen in dem Testssignal hervorgerufen. Der Analysekontakt kann ohne nasschemisches Ätzen der Verkapselungsmasse freigelegt werden, beispielsweise durch mechanischen Materialabtrag (z.B. durch Schleifen und/oder Fräsen) und/oder durch Abtragen der Verkapselungsmasse mit Hilfe eines Energiestrahls, insbesondere eines Laserstrahls. Dabei ist es sogar möglich, die Verkapselungsmasse nur über einem Teil der Oberfläche des Halbleiterchips abzutragen, wobei dieser Oberflächenteil von den Rändern des Halbleiterchips beabstandet sein kann, so dass der Analysekontakt auch bei einem Halbleiterbauelement, das an allen vier Seiten von außen zugängliche elektrische Anschlusskontakte aufweist, freigelegt werden kann.

Bei einer vorteilhaften Ausgestaltung der Erfindung ist der Analysekontakt über eine erste Verbindungsleitung mit einem an die Verkapselungsmasse angrenzenden, von außen zugänglichen Anschlusskontakt und dieser Anschlusskontakt über eine zweite Verbindungsleitung mit einer von der Anschlussfläche beabstandeten elektrischen Anschlussstelle des Halbleiterchips verbunden, wobei die Verbindungsleitungen derart im Inneren der Verkapselungsmasse angeordnet sind, dass der Analysekontakt während oder nach dem bereichsweisen Abtragen der Verkapselungsmasse von der ersten Verbindungsleitung abgetrennt werden kann, ohne die zweite Verbindungsleitung zu unterbrechen. An dem von außen zugänglichen Anschlusskontakt und damit auch an dem Analysekontakt kann während des normalen Betriebs des Halbleiterbauelements eine vorbestimmte elektrische Spannung anliegen, beispielsweise die Betriebsspannung oder Massepotential, so dass die Anschlussfläche für das Testssignal dann auf einem definierten Potential liegt. Dadurch wird ein störungsfreier Betrieb des Halbleiterbauelements ermöglicht. Nach und/oder während des partiellen Abtragens der Verkapselungsmasse wird die elektrische Verbindung zwischen dem Analysekontakt und dem Anschlusskontakt unterbrochen, so dass dann das eigentliche Testsignal an dem Analysekontakt abgreifbar und/oder in diesen einspeisbar ist. Die Verbindungsleitungen sind bevorzugt als Bonddrähte ausgestaltet.

Bei einer zweckmäßigen Ausführungsform der Erfindung steht der Analysekontakt quer zur Haupterstreckungsebene des Halbleiterchips über einen an die Anschlussfläche angrenzenden Oberflächenbereich des Halbleiterchips über. Die Verkapselungsmasse kann dann zum Freilegen des Analysekontakts an der Oberseite des Halbleiterbauelements bereichsweise abgetragen werden.

Vorteilhaft ist, wenn der Analysekontakt mindestens zwei quer zur Haupterstreckungsebene des Halbleiterchips übereinander gestapelte Bondstellen aufweist und wenn mindestens eine an der Oberfläche des Halbleiterchips vorgesehene elektrische Anschlussstelle über eine einfache Bondstelle und/oder eine Anzahl übereinander gestapelter Bondstellen, die geringer ist als die Anzahl der übereinander gestapelten Bondstellen des Analysekontakts, mit einem Bonddraht verbunden ist. Der Analysekontakt kann dann bei der Herstellung des Halbleiterbauelements auf einfache Weise derart auf den Halbleiterchip aufgebracht werden, dass der die an der mindestens einen Anschlussstelle angeordnete Bondstelle überragt. Die gestapelte Bondstelle ist bevorzugt als sogenannter stacked Ball Bond ausgestaltet.

Bei einer vorteilhaften Ausgestaltung der Erfindung steht der Analysekontakt weiter über die an die Anschlussfläche angrenzende Oberfläche des Halbleiterchips über als alle anderen im Inneren der Verkapselungsmasse angeordneten elektrisch leitenden Teile, die mit dem Halbleiterchip elektrisch leitend verbunden sind. Der mindestens eine Analysekontakt kann dann auf einfache Weise durch ganzflächiges Abtragen einer oberflächennahen Schicht der Verkapselungsmasse zum Abgreifen und/oder Anlegen des Testsignals zugänglich gemacht werden.

Vorteilhaft ist, wenn der Halbleiterchip zumindest einen ersten Randbereich und einen quer und/oder parallel dazu verlaufenden zweiten Randbereich aufweist, wenn der Halbleiterchip in dem ersten Randbereich mindestens eine Anschlussstelle aufweist, die über einen in die Verkapselungsmasse eingebetteten Bonddraht mit einem von außen zugänglichen Anschusskontakt verbunden ist, und wenn in dem zweiten Randbereich keine Anschlussstelle über einen Bonddraht mit einem verbunden ist. Der mindestens eine Analysekontakt kann dann in dem zweiten Randbereich oder benachbart dazu angeordnet sein. Somit kann der Analysekontakt durch bereichsweises Abtragen von Verkapselungsmasse an der Seite des Halbleiterbauelements, an der keine Bonddrähte vorgesehen sind, auf einfache Weise freigelegt werden.

Bei einer bevorzugten Ausführungsform der Erfindung ist der Halbleiterchip in Abhängigkeit von einer an der Anschlussfläche anliegenden elektrischen Spannung zwischen einem Betriebszustand und einem Testzustand umschaltbar. Dabei ist es sogar möglich, dass in dem Testzustand über die von außen zugänglichen Anschlusskontakte Analysedaten und/oder Analysesignale aus dem Halbleiterchip auslesbar sind, die im Betriebszustand gegen Auslesen gesperrt sind. Somit kann das Halbleiterbauelement noch genauer auf eventuelle Fehler untersucht werden.

Nachfolgend sind Ausführungsbeispiele der Erfindung anhand der Zeichnung näher erläutert. Es zeigen:
- Fig. 1: eine Teilseitenansicht eines Halbleiterbauelements, das einen in eine Verkapselungsmasse eingebetteten Halbleiterchip aufweist, wobei die Verkapselungsmasse transparent dargestellt ist, um die Sicht auf die darin befindlichen Teile des Halbleiterbauelements freizugeben, und wobei nur einige der Bonddrähte dargestellt sind,
- Fig. 2: eine Teilaufsicht auf das in Fig. 1 gezeigte Halbleiterbauelement, wobei die Verkapselungsmasse wiederum transparent dargestellt ist,
- Fig. 3: eine Teilseitenansicht des Halbleiterbauelements nach dem partiellen Entfernen der Verkapselungsmasse, wobei nur zwei der sechs Bonddrähte dargestellt sind,
- Fig. 4: eine Teilaufsicht auf das in Fig. 3 gezeigte Halbleiterbauelement, wobei der Bereich, in dem die Verkapselungsmasse teilweise abgetragen wurde, schraffiert ist,
- Fig. 5: eine Teilseitenansicht des in Fig. 1 und 2 gezeigten Halbleiterbauelements nach dem partiellen Entfernen der Verkapselungsmasse, wobei nur zwei der sechs Bonddrähte dargestellt sind,
- Fig. 6: eine Teilaufsicht auf das in Fig. 5 gezeigte Halbleiterbauelement, wobei ein Bereich, in dem die Verkapselungsmasse teilweise abgetragen wurde, schraffiert ist, und
- Fig. 7: eine Teilaufsicht auf ein Halbleiterbauelement, das an mehreren Seiten Anschlusskontakte aufweist, wobei die Verkapselungsmasse transparent und ein Bereich, in dem die Verkapselungsmasse abgetragen wurde, schraffiert ist,
- Fig. 8: einen Teilquerschnitt durch das in Fig. 7 gezeigte Halbleiterbauelement, wobei die Verkapselungsmasse transparent dargestellt und nur zwei von neun Bonddrähte gezeichnet sind,
- Fig. 9: eine Darstellung ähnlich Fig. 7, wobei die Verkapselungsmasse jedoch in einem anderen Bereich teilweise abgetragen wurde.

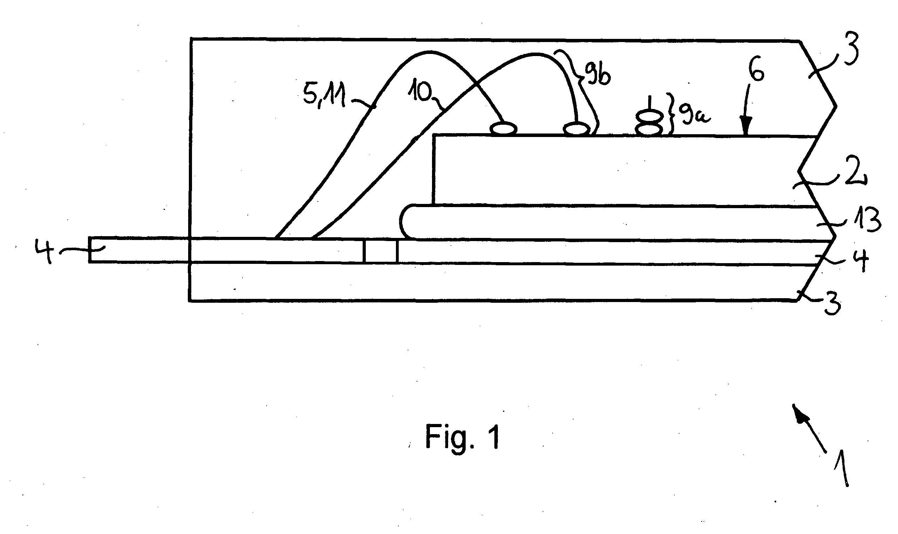

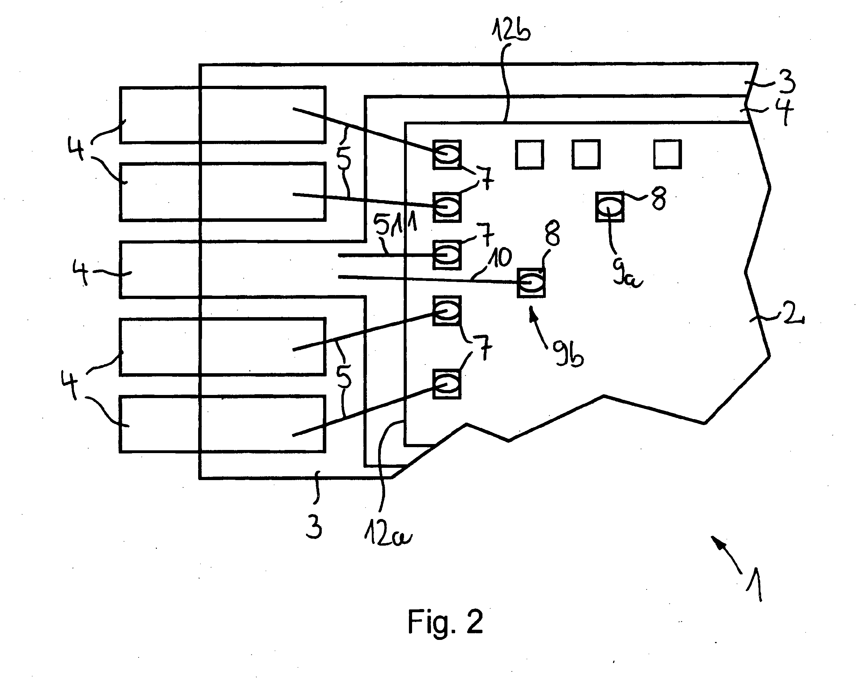

Ein in Fig. 1 und 2 im Ganzen mit 1 bezeichnetes Halbleiterbauelement weist einen Halbleiterchip 2 auf, in den eine in der Zeichnung nicht näher dargestellte elektrische Schaltung integriert ist. Der Halbleiterchip 2 ist in eine elektrisch isolierende Verkapselungsmasse 3 eingebettet, die als Gehäuse für den Halbleiterchip 2 dient. Die Verkapselungsmasse 3 besteht vorzugsweise aus Kunststoff, mit dem der Halbleiterchip 2 umspritzt ist.

In Fig. 2 ist erkennbar, dass das Halbleiterbauelement mehrere elektrische Anschlusskontakte 4 hat, die über Bonddrähte 5 mit an der Oberfläche 6 des Halbleiterchips 2 angeordneten Anschlussstellen 7 verbunden sind. Die Anschlusskontakte 4 haben jeweils einen mit der Verkapselungsmasse 3 umspritzten ersten Teilbereich und einen zweiten Teilbereich, der freiliegt und von außen zugänglich ist.

Die Bonddrähte 5 sind jeweils mit ihrem einen Ende über eine erste Bondstelle mit der ihnen zugeordneten Anschlussstelle 7 des Halbleiterchips 2 und über eine zweite Bondstelle mit dem ihnen zugeordneten Anschlusskontakt 4 elektrisch leitend verbunden. Die Bonddrähte 5 verlaufen vollständig im Inneren der Vergussmasse mit Abstand zu deren äußerer Oberfläche.

Der Halbleiterchip 2 hat außerdem an seiner Oberfläche 6 mehrere Anschlussflächen 8 für Testssignale. Aufjeder Anschlussfläche 8 ist jeweils ein Analysekontakt 9a, 9b angeordnet, der über die Oberfläche 6 des Halbleiterchips 2 übersteht. Der Überstand kann mindestens 5%, insbesondere mindestens 10% und bevorzugt mindestens 25% der Wandstärke, die der an den Analysekontakt 9a, 9b angrenzende Bereich der Verkapselungsmasse 3 aufweist, betragen.

Der Analysekontakt 9a, 9b besteht jeweils aus einem elektrisch leitenden Werkstoff und ist mit der ihm zugeordneten Anschlussfläche 8 elektrisch verbunden.

In Fig. 1 ist erkennbar, dass die Analysekontakte 9a, 9b vollständig im Inneren der Verkapselungsmasse 3 mit Abstand zu deren äußerer Oberfläche angeordnet sind. Durch Abtragen einer oberflächennahen Schicht der Verkapselungsmasse 3 kann der Analysekontakt 9a, 9b freigelegt werden. Das Abtragen der Verkapselungsmasse 3 kann mittels eines mechanischen Werkzeugs, durch Einwirkung einer Chemikalie und/oder mit Hilfe eines Energiestrahls erfolgen.

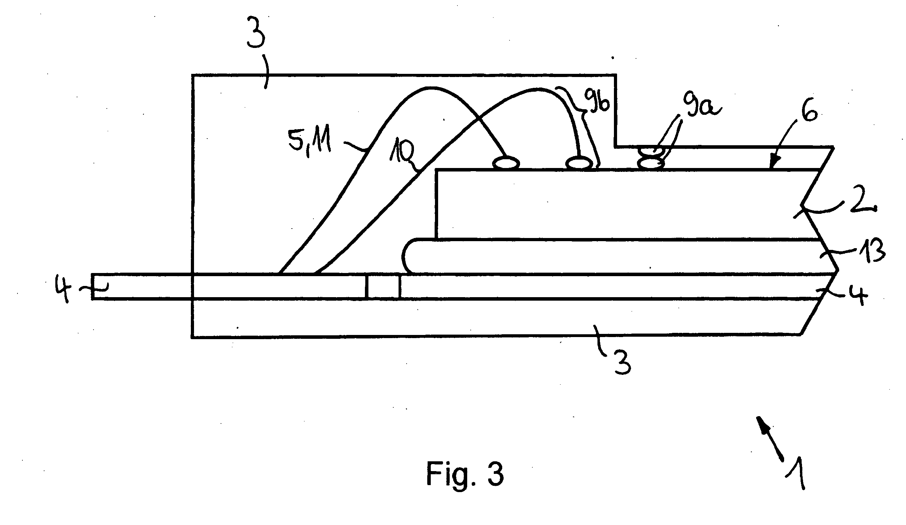

In Fig. 3 ist erkennbar, dass der Materialabtrag gestoppt wird, sobald ein ausreichend großer Teilbereich des Analysekontakts 9a, 9b freigelegt ist, der dazu geeignet ist, mit einer in der Zeichnung nicht näher dargestellten Kontaktnadel eines Analysegeräts elektrisch kontaktiert zu werden. Über die Kontaktnadel und den Analysekontakt 9a, 9b kann dann das Testsignal an der Anschlussfläche 8 abgegriffen und/oder in diese eingespeist werden, um die elektrische Schaltung beispielsweise nach dem Auftreten eines Defekts an dem Halbleiterbauelement 1 zu untersuchen. Unter dem Bereich, in dem die Verkapselungsmasse 3 abgetragen wurde, verbleibt eine ausreichend dicke Schicht der Verkapselungsmasse 3, über die der Halbleiterchip 2 weiterhin elektrisch isoliert sowie gegen mechanische Beschädigung und/oder Umwelteinflüsse geschützt ist.

In Fig. 3 ist erkennbar, dass die Verkapselungsmasse 3 nur über einem Teilbereich der Oberfläche 6 des Halbleiterchips 2 abgetragen wird. In einem dazu benachbarten Teilbereich Oberfläche 6, über dem die Bonddrähte 5 angeordnet sind, erfolgt kein Materialabtrag. Dadurch wird vermieden, dass die Bonddrähte beim Öffnen des Halbleiterbauelements 1 beschädigt werden.

Der Analysekontakt 9b ist über eine erste Verbindungsleitung 10 mit einem Anschlusskontakt 4 verbunden, der während des normalen Betriebs des Halbleiterbauelements 1 auf einem konstanten elektrischen Potential liegt. Die erste Verbindungsleitung 10 ist einstückig mit dem Analysekontakt 9b ausgebildet. Der Anschlusskontakt 4 ist über eine zweite Verbindungsleitung 11 mit einer elektrischen Anschlussstelle 7 des Halbleiterchips 2 verbunden. Somit liegen während des normalen Betriebs des Halbleiterbauelements 1 sowohl die Anschlussstelle 7 als auch die Anschlussfläche 8 auf dem konstanten elektrischen Potential.

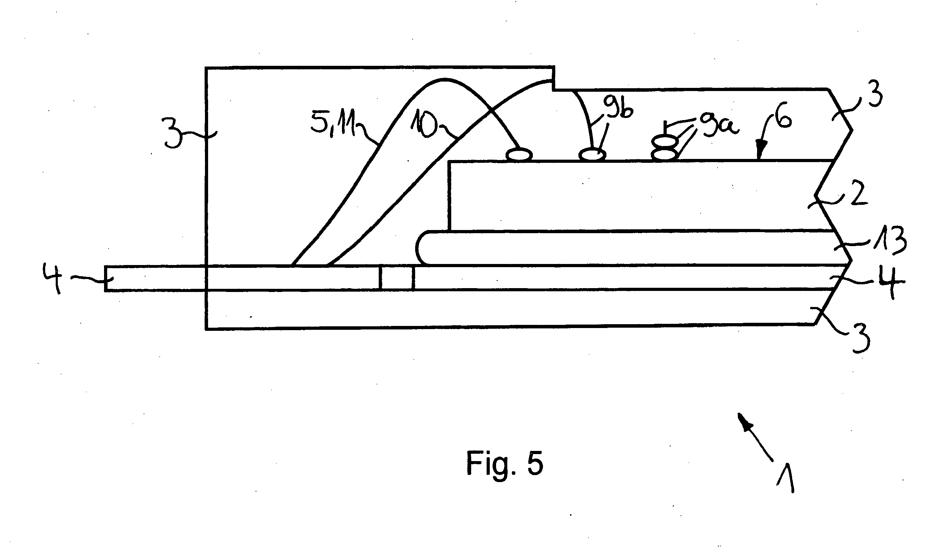

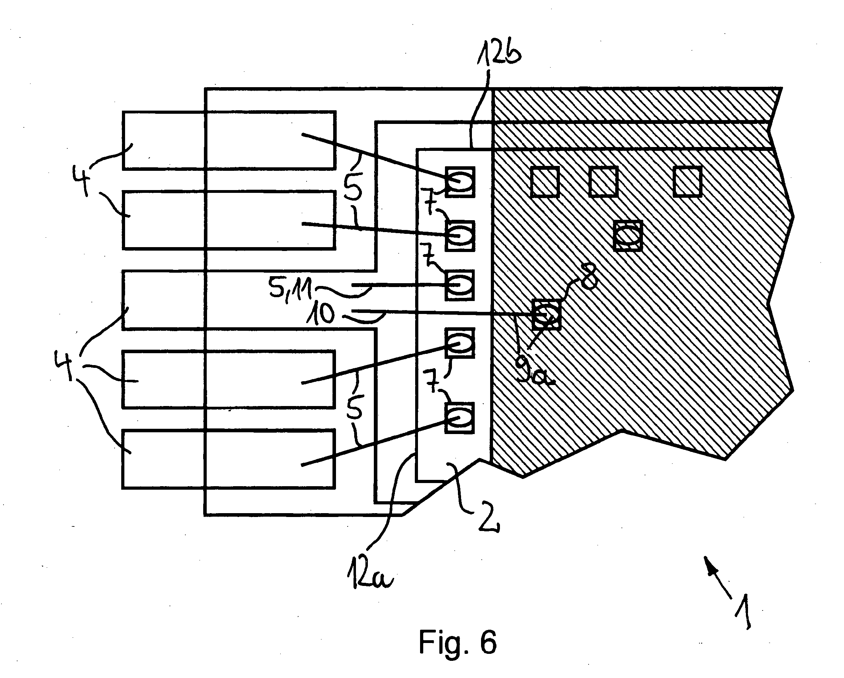

- In Fig. 5 und 6: ist erkennbar, dass das die Verkapselungsmasse 3 derart partiell von dem Halbleiterbauelement 1 abgetragen werden kann, dass die Verbindung zwischen dem Analysekontakt 9b und der ersten Verbindungsleitung 10 unterbrochen und der Analysekontakt 9b gleichzeitig freigelegt wird. Dabei bleibt die zweite Verbindungsleitung erhalten. Unter dem Bereich, in dem die Verkapselungsmasse 3 abgetragen wurde, verbleibt nach Beendigung des Materialabtrags wiederum
eine Schicht der Verkapselungsmasse 3, die den Halbleiterchip 2 bedeckt und vor Beschädigung schützt. Die Verbindungsleitungen 10, 11 sind vorzugsweise durch Bonddrähte gebildet.

In Fig. 1, 3 und 5 ist erkennbar, dass der Analysekontakt 9a also so genannter stacked Ball Bond ausgebildet ist, d.h. er hat zwei quer zur Haupterstreckungsebene des Halbleiterchips 2 übereinander gestapelte Bondstellen. Außerdem ist erkennbar, dass die Bonddrähte 5 nur über einfache Bondstellen mit den Anschlussstellen 7 verbunden sind.

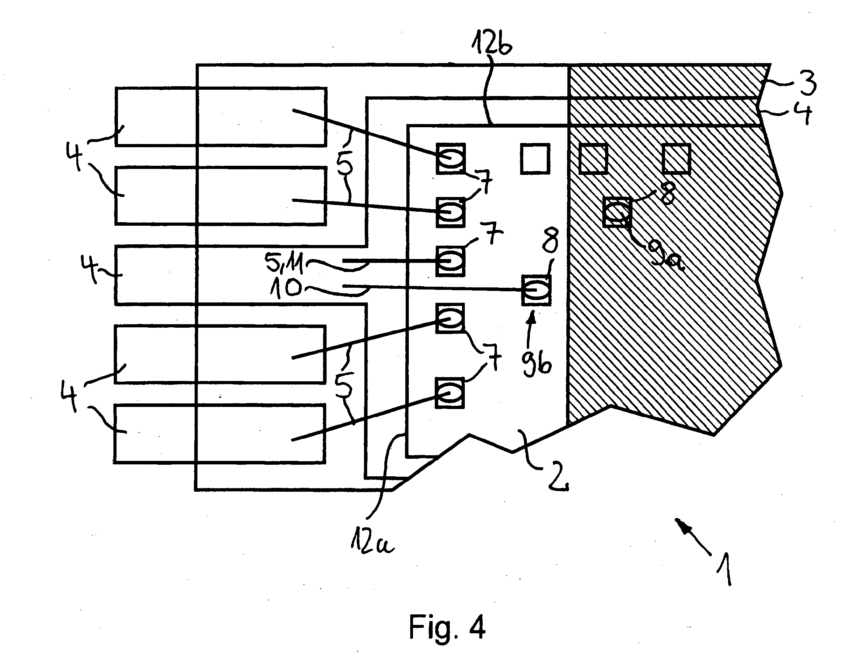

Bei den in Fig. 4 und 6 gezeigten Ausführungsbeispielen hat der Halbleiterchip 2 quer zueinander verlaufende Randbereiche 12a, 12b. In einem ersten Randbereich 12a sind die mit den Bonddrähten 5 verbundenen Anschlussstellen 7 angeordnet und in einem zweiten Randbereich 12b sind keine Bonddrähte 5 vorgesehen. Der Bereich, in dem die Verkapselungsmasse 3 partiell abgetragen wird, befindet sich außerhalb des ersten Randbereichs 12. Der Bereich, in dem die Verkapselungsmasse 3 abgetragen wird, erstreckt sich unterbrechungsfrei von einem dem zweiten Randbereich 12b zugewandten Außenrand der Verkapselungsmasse 3 zu einem davon beabstandeten weiteren Außenrand der Verkapselungsmasse 3.

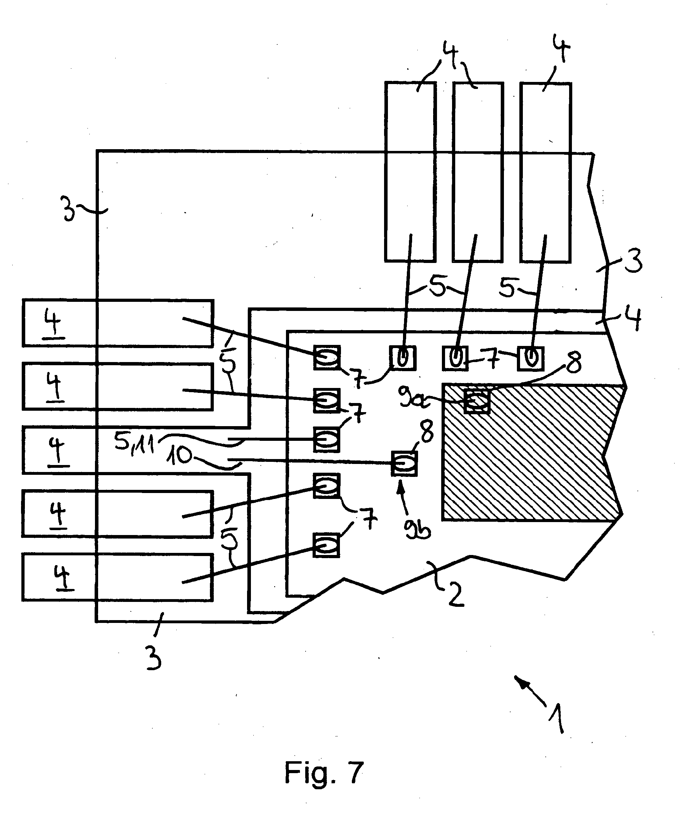

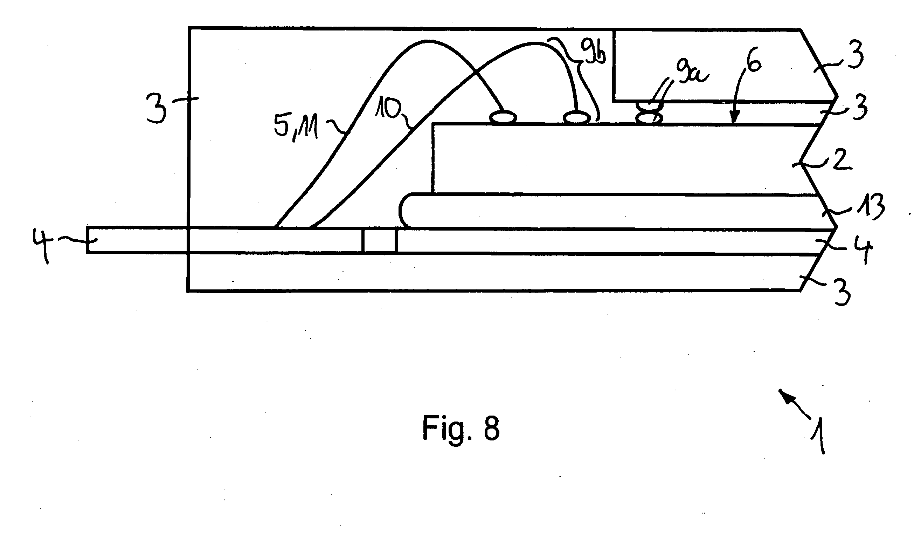

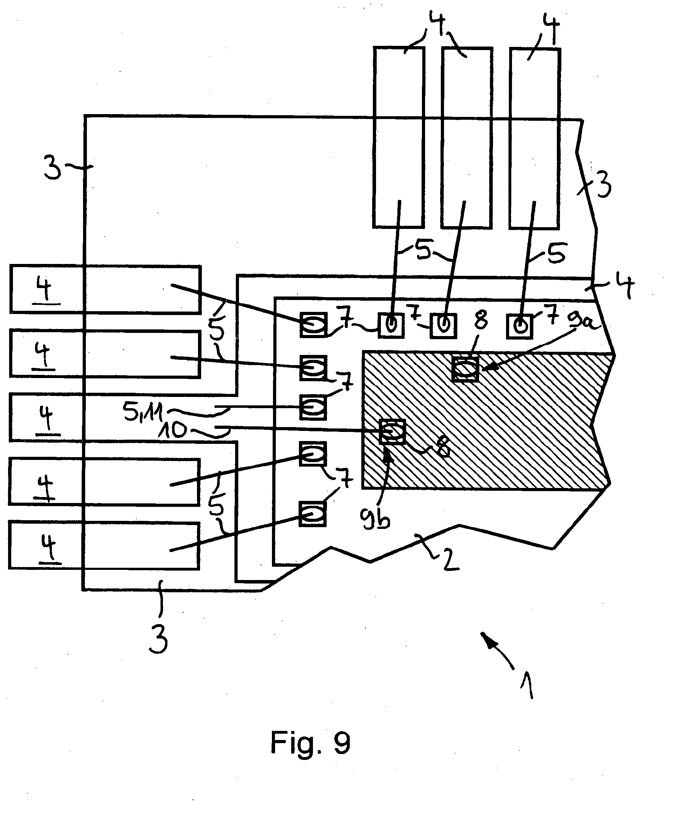

Bei dem in Fig. 7-9 gezeigten Ausführungsbeispiel hat das Halbleiterbauelement 1 an mehreren, quer zueinander verlaufenden Randbereichen Anschlusskontakte 4, die über Bonddrähte 5 mit Anschlussstellen 7 des Halbleiterchips 2 verbunden sind. Bei diesem Ausführungsbeispiel erfolgt der Materialabtrag mit Abstand zu den Außenrändern der Verkapselungsmasse 3. Erwähnt werden soll noch, dass ein Anschlusskontakt 4 über eine Klebstoffschicht 13 mit der den Analysekontakten 9a, 9b abgewandten Rückseite des Halbleiterchips 2 verbunden ist.

## Patentansprüche

1. Halbleiterbauelement (1), mit mindestens einem Halbleiterchip (2), in den eine elektrische Schaltung integriert ist, wobei der Halbleiterchip (2) mindestens eine Anschlussfläche (8) für ein Testssignal aufweist, und wobei der Halbleiterchip (2) von einer die Anschlussfläche (8) überdeckenden elektrisch isolierenden, eine Außenoberfläche aufweisenden Verkapselungsmasse (3) umgrenzt ist, wobei die Anschlussfläche (8) mit einem über die Oberfläche (6) des Halbleiterchips (2) überstehenden, im Inneren der Verkapselungsmasse (3) angeordneten Analysekontakte (9a, 9b) elektrisch leitend verbunden ist, und der Analysekontakt (9a, 9b) mit Abstand zur Außenoberfläche der Verkapselungsmasse (3) angeordnet ist,
**dadurch gekennzeichnet, dass**
ein Teil des Analysekontakts (9a, 9b) freigelegt ist, wobei eine ausreichend dicke Schicht der Verkapslungsmasse (3) in dem Abtragungsbereich auf der Oberfläche (b) des Halbleiterchips (2) ausgebildet ist, und der Analysekontakt (9a, 9b) über eine erste Verbindungsleitung (10) mit einem an die Verkapselungsmasse (3) angrenzenden, von außen zugänglichen Anschlusskontakt (4) und dieser Anschlusskontakt (4) über eine zweite Verbindungsleitung (11) mit einer von der Anschlussfläche (8) beabstandeten elektrischen Anschlussstelle (7) des Halbleiterchips (2) verbunden ist, und dass die Verbindungsleitungen (10, 11) derart im Inneren der Verkapselungsmasse (3) angeordnet sind, dass der Analysekontakt (9a, 9b) freigelegt und von der ersten Verbindungsleitung (10) getrennt ist, ohne die zweite Verbindungsleitung (11) zu unterbrechen.

2. Halbleiterbauelement (1) nach Anspruch 1, **dadurch gekennzeichnet, dass** der Analysekontakt (9a, 9b) quer zur Haupterstreckungsebene des Halbleiterchips (2) über einen an die Anschlussfläche (8) angrenzenden Oberflächenbereich des Halbleiterchips (2) übersteht.

3. Halbleiterbauelement (1) nach Anspruch 1 oder 2, **dadurch gekennzeichnet, dass** der Analysekontakt (9a, 9b) mindestens zwei quer zur Haupterstreckungsebene des Halbleiterchips (2) übereinander gestapelte Bondstellen aufweist und dass mindestens eine an der Oberfläche (6) des Halbleiterchips (2) vorgesehene elektrische Anschlussstelle (7) über eine einfache Bondstelle und/oder eine Anzahl übereinander gestapelter Bond stellen, die geringer ist als die Anzahl der übereinander gestapelten Bondstellen des Analysekontakts (9a, 9b), mit einem Bonddraht (5) verbunden ist.

4. Halbleiterbauelement (1) nach einem der Ansprüche 1 bis 3, **dadurch gekennzeichnet, dass** der Analysekontakt (9a, 9b) weiter über die an die Anschlussfläche (8) angrenzende Oberfläche (6) des Halbleiterchips (2) übersteht als alle anderen im Inneren der Verkapselungsmasse (3) angeordneten elektrisch leitenden Teile, die mit dem Halbleiterchip (2) elektrisch leitend verbunden sind.

5. Halbleiterbauelement (1) nach einem der Ansprüche 1 bis 4, **dadurch gekennzeichnet, dass** der Halbleiterchip (2) zumindest einen ersten Randbereich (12a) und einen quer und/oder parallel dazu verlaufenden zweiten Randbereich (12b) aufweist, dass der Halbleiterchip (2) in dem ersten Randbereich (12a) mindestens eine Anschlussstelle (7) aufweist, die über einen in die Verkapselungsmasse (3) eingebetteten Bonddraht (5) mit einem von außen zugänglichen Anschlusskontakt (4) verbunden ist, und dass in dem zweiten Randbereich (12b) keine Anschlussstelle über einen Bonddraht mit einem Anschlusskontakt verbunden ist.

## Claims

1. Semiconductor component (1) with at least one semiconductor chip (2), in which an electrical circuit is integrated, wherein the semiconductor chip (2) has at least one terminal surface (8) for a test signal, and wherein the semiconductor chip (2) is encapsulated by an electrically insulating encapsulating material (3) covering the terminal surface (8) and having an outer surface, wherein the terminal surface (8) is electrically conductively connected with an analysis contact (9a, 9b) which protrudes beyond the surface (6) of the semiconductor chip (2) and is arranged in the interior of the encapsulating material (3), and the analysis contact (9a, 9b) is arranged at a spacing from the outer surface of the encapsulating mass (3),
**characterised in that**
a part of the analysis contact (9a, 9b) is exposed, wherein a sufficiently thick layer of the encapsulating material (3) is formed on the surface (b) of the semiconductor chip (2) in the removal region, and the analysis contact (9a, 9b) is connected by way of a first connecting line (10) with an externally accessible connecting contact (4) adjoining the encapsulating material (3) and this connecting contact (4) is connected by way of a second connecting line (11) with an electrical terminal point (7), which is spaced from the terminal surface (8), of the semiconductor chip (2), and that the connecting lines (10, 11) are so arranged in the interior of the encapsulating material (3) that the analysis contact (9a, 9b) is exposed and is separated from the first connecting line (10) without interrupting the second connecting line (11).

2. Semiconductor component (1) according to claim 1, **characterised in that** the analysis contact (9a, 9b) projects transversely to the main dimensional plane of the semiconductor chip (2) beyond a surface region, which adjoins the terminal surface (8), of the semiconductor chip (2).

3. Semiconductor component (1) according to claim 1 or 2, **characterised in that** the analysis contact (9a, 9b) has at least two bond points stacked one above the other transversely to the main dimensional plane of the semiconductor chip (2) and that at least one electrical terminal point (7), which is provided at the surface (6) of the semiconductor chip (2), is connected with a bond wire (5) by way of a single bond point and/or a number of bond points stacked one above the other, which number is smaller than the number of the bond points, which are stacked one above the other, of the analysis contact (9a, 9b).

4. Semiconductor component (1) according to any one of claims 1 to 3, **characterised in that** the analysis contact (9a, 9b) projects further beyond the surface (6) of the semiconductor chip (2) adjoining the terminal surface (8) than all other electrically conductive parts which are arranged in the interior of the encapsulating material (3) and electrically conductively connected with the semiconductor chip (2).

5. Semiconductor component (1) according to any one of claims 1 to 4, **characterised in that** the semiconductor chip (2) has at least one first edge region (12a) and a second edge region (12b), extending transversely and/or parallelly thereto, that the semiconductor chip (2) has in the first edge region (12a) at least one terminal point (7) which is connected with an externally accessible connecting contact (4) by way of a bond wire (5) embedded in the encapsulating material (3) and that no connecting point is connected in the second edge region (12b) with a terminal contact by way of a bond wire.

## Revendications

1. Composant semi-conducteur (1), avec au moins une puce semi-conductrice (2), dans laquelle un circuit électrique est intégré, dans lequel la puce semi-conductrice (2) présente au moins une face de raccordement (8) pour un signal de test, et dans lequel la puce semi-conductrice (2) est enveloppée par une masse d'enrobage (3) électriquement isolante recouvrant la face de raccordement (8) et présentant une surface extérieure, dans lequel la face de raccordement (8) est reliée de façon électriquement conductrice à un contact d'analyse (9a, 9b) disposé à l'intérieur de la masse d'enrobage (3) et saillant au-dessus de la surface (6) de la puce semi-conductrice (2), et le contact d'analyse (9a, 9b) est disposé à distance de la surface extérieure de la masse d'enrobage (3), **caractérisé en ce qu'**une partie du contact d'analyse (9a, 9b) est dénudée, dans lequel une couche suffisamment épaisse de la masse d'enrobage (3) est formée dans la région d'érosion sur la surface (b) de la puce semi-conductrice (2), et le contact d'analyse (9a, 9b) est relié par une première ligne de liaison (10) à un contact de raccordement (4) accessible de l'extérieur et adjacent à la masse d'enrobage (3) et ce contact de raccordement (4) est relié par une deuxième ligne de liaison (11) à un point de raccordement électrique (7) de la puce semi-conductrice (2) espacé de la face de raccordement (8), et **en ce que** les lignes de liaison (10, 11) sont disposées à l'intérieur de la masse d'enrobage (3) de telle manière que le contact d'analyse (9a, 9b) soit dénudé et qu'il soit séparé de la première ligne de liaison (10), sans interrompre la deuxième ligne de liaison (11).

2. Composant semi-conducteur (1) selon la revendication 1, **caractérisé en ce que** le contact d'analyse (9a, 9b) est saillant au-dessus d'une région de la surface de la puce semi-conductrice (2) adjacente à la face de raccordement (8), transversalement au plan d'extension principal de la puce semi-conductrice (2).

3. Composant semi-conducteur (1) selon la revendication 1 ou 2, **caractérisé en ce que** le contact d'analyse (9a, 9b) présente au moins deux points de jonction empilés l'un sur l'autre transversalement au plan d'extension principal de la puce semi-conductrice (2) et **en ce qu'**au moins un point de raccordement électrique (7) prévu sur la surface (6) de la puce semi-conductrice (2) est relié à un fil de jonction (5) par un simple point de jonction et/ou un nombre de points de jonction empilés l'un sur l'autre, qui est plus petit que le nombre des points de jonction du contact d'analyse (9a, 9b) empilés l'un sur l'autre.

4. Composant semi-conducteur (1) selon l'une quelconque des revendications 1 à 3, **caractérisé en ce que** le contact d'analyse (9a, 9b) est davantage saillant au-dessus de la surface (6) de la puce semi-conductrice (2) adjacente à la face de contact (8) que toutes les autres parties électriquement conductrices disposées à l'intérieur de la masse d'enrobage (3), qui sont reliées de façon électriquement conductrice à la puce semi-conductrice (2).

5. Composant semi-conducteur (1) selon l'une quelconque des revendications 1 à 4, **caractérisé en ce que** la puce semi-conductrice (2) présente au moins une première région de bord (12a) et une deuxième région de bord (12b) s'étendant transversalement et/ou parallèlement à celle-ci, **en ce que** la puce semi-conductrice (2) présente dans la première région de bord (12a) au moins un point de raccordement (7), qui est relié à au moins un contact de raccordement (4) accessible de l'extérieur par un fil de liaison (5) noyé dans la masse d'enrobage (3), et **en ce qu'**aucun point de raccordement dans la région de bord (12b) n'est relié à un contact de raccordement par un fil de liaison.
